# EUROPEAN PATENT APPLICATION

(11) **EP 2 463 913 A1**
(43) Date of publication of application: **13.06.2012**
(21) Application number: 10194716.6
(22) Date of filing: 13.12.2010
(51) Int. Cl.: H01L 29/74, H01L 29/744, H01L 21/332, H01L 29/08

(54) **Bipolar reverse-blocking non-punch-through power semiconductor device**

(71) Applicant: ABB Technology AG, 8050 Zürich (CH)
(72) Inventor: Vobecky, Jan, 5600 Lenzburg (CH); Klaka, Sven, 5245 Habsburg (CH)
(74) Representative: ABB Patent Attorneys

(57) **Abstract**

A bipolar reverse-blocking non-punch-through power semiconductor device with a blocking voltage of at least 1000 V is provided. It comprises a semiconductor wafer (2) with an inner region (22) and a termination region (24), which surrounds the inner region (22). A cathode contact (3) is arranged on a cathode side (31) and a anode contact (4) on an anode side (41). The wafer (2) comprises a drift layer (26) of a first conductivity type, a base layer of a second conductivity type on the drift layer (26), which is arranged towards the cathode side (31) and an anode layer of the second conductivity type, which is arranged towards the anode side (41). First guard rings (9) of the second conductivity type are arranged on the cathode side (31) in the termination region (24). On the anode side (41) in the termination region (24) second guard rings (95) of the second conductivity type are arranged. The first and second guard rings (9, 95) are fully floating. The base layer and the anode layer have both a thickness (52, 62) of at most 40 µm.

## Description

### Technical Field

The invention relates to the field of power electronics and more particularly to a bipolar reverse-blocking non-punch-through power semiconductor device with a blocking voltage of at least 1000 V according to the preamble of claim 1 and a method for manufacturing such a semiconductor device.

### Background Art

In WO 2004/040654 a thyristor is described, which comprises a semiconductor wafer 2 with an inner region 22 and a termination region 24, which surrounds the inner region 22, a cathode contact 3 being formed on a cathode side 31 of the wafer and an anode contact 4 being formed on an anode side 41 of the wafer opposite the cathode side 31. The wafer 2 comprises an n-doped drift layer 26 and a p doped base layer 5 with a base layer thickness 52, which is arranged on the drift layer 26 towards the cathode side 31 and contacts the cathode contact 3. A p doped anode layer 6 is arranged on the drift layer 26 towards the anode side 41 and contacts the anode contact 4, wherein the anode layer 6 has an anode layer thickness 62. First guard rings 9, which are p doped, are arranged on the cathode side 31 in the termination region 24. The wafer is terminated in the termination region 24 with a positive bevel, i.e. the area of the wafer on the highly-doped anode-side 41 is higher than on the lower-doped cathode side 31 and the wafer area is increasing with a constant angle between the two sides 31, 41.

For the manufacturing structure on the cathode side 31 there is a mask placed on the cathode side 31 which covers the termination region 24. P doped particles are applied on the cathode side 31 and, thus the p doped base layer 5 is created. Afterwards another mask is placed on the cathode side 31, which covers the inner region 22, and the wafer 2 is treated again with p doped particles on the cathode side 31 in order to create the first guard rings 9.

### Disclosure of Invention

It is an object of the invention to provide a bipolar reverse-blocking non-punch-through power semiconductor device with improved electrical parameters like on-state voltage drop V_{T}, improved reverse recovery charge Qᵣᵣ and surge current capability while keeping other electrical parameters relevant for proper operation like reverse and forward blocking capability at the level of prior art devices and to provide a cheaper and faster manufacturing method for such a device.

This object is achieved by a bipolar reverse-blocking non-punch-through power semiconductor device according to claim 1 and by manufacturing method according to claim 7.

The inventive bipolar reverse-blocking non-punch-through power semiconductor device with a blocking voltage of at least 1000 V, in particular of at least 1600 V up to 10 kV, comprises a semiconductor wafer and a cathode contact being formed on top of a cathode side of the wafer and an anode contact being formed on top of an anode side of the wafer opposite the cathode side. The wafer comprises in the central part of the wafer an inner region, which is arranged throughout the wafer between the between the cathode and anode side and a termination region, which surrounds the inner region in a plane parallel to the cathode side. The wafer has a wafer thickness, which is measured between the cathode and anode side.

The wafer comprises a drift layer of a first conductivity type, a base layer of a second conductivity type having a base layer thickness, which is arranged on the drift layer towards the cathode side and contacts the cathode contact, and an anode layer of the second conductivity type having an anode layer thickness, which is arranged on the drift layer towards the anode side and contacts the anode contact. The base layer and the anode layer have a thickness of at most 40 µm, in particular at most 30 µm.

At least one first guard ring of the second conductivity type with a first guard ring thickness is arranged on the cathode side in the termination region. Each of the first guard rings is separated from the base layer and from any other first guard ring by the drift layer.

At least one second guard ring of the second conductivity type with a second guard ring thickness is arranged on the anode side in the termination region. Each of the second guard rings is separated from the base layer and from any other second guard ring by the drift layer.

The first and second guard rings are floating. The thickness of the first and second guard rings is typically also at most 40 µm, in particular at most 30 µm.

The reduced thickness of the base layer and anode layer compared to prior art devices brings reduced on-state voltage drop V_{T}. Also other parameters like reverse recovery charge Qᵣᵣ, turn-off time tq and maximal surge current are improved by the reduced thickness, while other relevant parameters are kept at the level as for prior art devices. Compared to prior art, this improvement is achieved by aggressive thinning of the base layer and anode layer. The total device thickness can be reduced due to the thinner base layer and anode layer, while the reverse and forward blocking capability is maintained by means of the drift layer having the same thickness. It is the guard rings, which allow to have the base and anode layers much thinner, what is contrary to devices with a bevel.

A Phase Control Thyristor (PCT), compared to existing thyristors with great depth of P-anode layer and P-base layer, has a lower on-state voltage drop V_{T} with high forward and reverse blocking capability at the same time. The lower V_{T} implies for example a higher energy saving and selling price of a HVDC system, but can be also beneficial for other parameters in other applications.

Because the PCT is non-punch-through device with symmetrical blocking, i.e. forward and reverse blocking, the application of a thinner drift layer with a field-stop (buffer) layer is not applicable. Consequently, the thickness of the drift layer must be conserved for a given voltage class. With the present invention the device comprises aggressively thinned layers of the second conductivity type on both main sides of the wafer, i.e. the anode and base layers. For example, the wafer thickness of a PCT with V_{RRM} = 8.5 kV can be reduced by about 10 %, for thicknesses of anode and P-base layers, which are reduced to about 25 % of the thicknesses of prior art devices.

Concerning the manufacturing of the inventive PCT, it can be processed at much thinner starting silicon wafer for a given voltage class. Further advantage of the present invention is the huge reduction of thermal budget (production cost), because the production of thinner layers requires lower diffusion time. As the dopant deposition can be replaced by ion-beam implantation, less high-temperature gettering steps (time) is required hereby also saving the thermal budget.

As no beveling step is required for the manufacturing of the inventive devices, these devices do not need mechanical manufacturing steps like grinding end therefore, the devices are easier to manufacture with higher reproducibility than devices having bevels. Furthermore, the absence of bevels allows to produce the PCTs as a plurality of small and even rectangular chips within a wafer of much higher diameter of e.g. 6 inch or even greater, which is an advantage concerning cost efficiency, or as single wafer devices. Any other desired design for the device can be chosen for the inventive devices, because there is no limitation to circular shapes due to the mechanical grinding process made for devices with bevels. The discrete devices of this invention may have a circular design with a diameter larger than 30 mm or a corresponding area for devices with other shapes.

### Brief Description of Drawings

The subject matter of the invention will be explained in more detail in the following text with reference to the attached drawings, in which:
- FIG 1: shows a prior art phase control thyristor as known from WO 2004/040654;
- FIG 2: shows a phase control thyristor according to the invention;
- FIG 3-11: show different steps of methods for manufacturing a semiconductor device according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

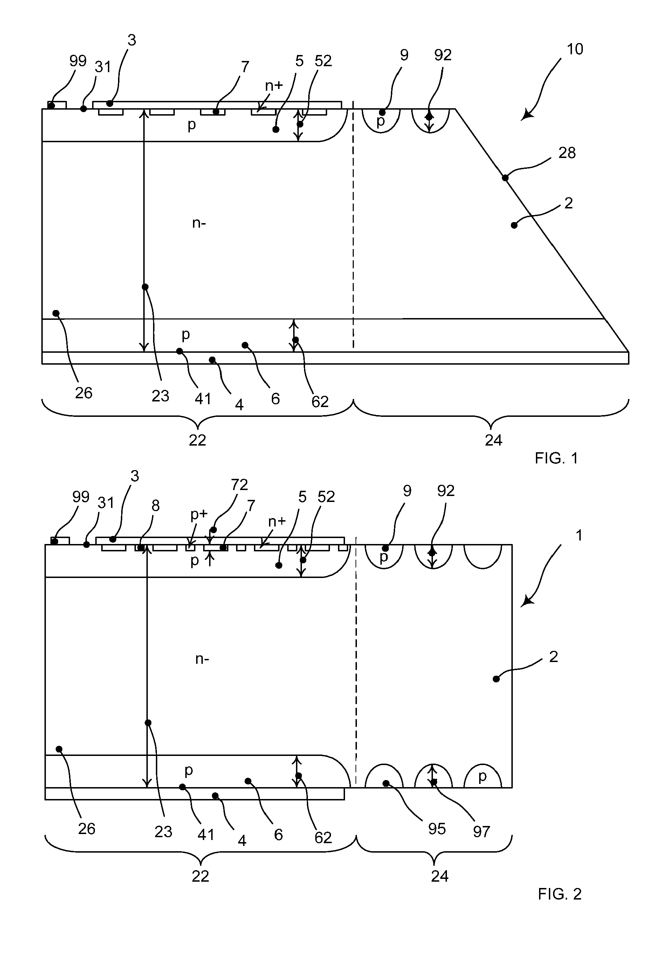

In FIG 2 a bipolar reverse-blocking non-punch-through power semiconductor device in form of a phase controlled thyristor (PCT) 1 with a blocking voltage of at least 1000 V according to the invention is shown. The device comprises a semiconductor wafer 2 with layers of different conductivity types, on which wafer 2 a cathode contact 3 is formed on a cathode side 31 of the wafer and an anode contact 4 is formed on a anode side 41 of the wafer opposite the cathode side 31. A low (n-) doped drift layer 26 is formed in the wafer. A p doped base layer 5 is arranged on the drift layer 26 towards the cathode side 31. It contacts the cathode contact 3. The base layer 5 has a base layer thickness 52, which is at most 40 µm, in particular at most 30 µm. The base layer thickness 52 is measured as the maximum distance, to which the base layer 5 extends from the cathode side 31 and in orthogonal projection to the cathode side 31.

The cathode side 31 shall be the plane, in which the surface of the base layer 5, i. e. that that side of the base layer 5, which is opposite to the drift layer 26, is positioned.

The wafer 2 comprises an inner region 22 with a wafer thickness 23 measured between the cathode and anode side 31, 41. The device thickness 23 is kept constant between the cathode side 31 and the anode side 41 up to the border of the device, i.e. there is no beveling of the wafer in the termination region 24. The wafer 2 further comprises a termination region 24, which surrounds the inner region 22 in a direction perpendicular to the cathode side 31. The cathode and anode contacts 3, 4 are laterally terminated within the inner region 22.

The inventive PCT has in addition to the before mentioned layers on the cathode side 31 an n doped cathode layer 7 with a cathode layer thickness 72, which is embedded into the p doped base layer 5 such that the cathode electrode 3 contacts the base layer 5 and the cathode layer 7. Base layer 5 and cathode layer 7 terminate on the outer surface of the wafer in the same plane. Alternatively, the cathode layer projects from the plane of the base layer 5.

Typically, a (p+) doped short region 8 is arranged in the same plane as the p doped base layer 5 and lateral to the cathode layer 7. A gate contact 99 is arranged on the cathode side 31 lateral to the cathode contact 3, e.g. at the center of the cathode side 31.

The base layer thickness 52 is greater than the cathode layer thickness 72 and, if present, also greater than a cathode short regions thickness, so that the base layer 5 separates the cathode layer/cathode short regions 7, 8 from the drift layer 26. In an exemplary embodiment this is ensured by the base layer thickness 52 being at least 8 µm, in another embodiment at least 10 µm.

Lateral to the base layer 5 in the termination region 24, at least one p doped ring-shaped first guard ring 9 is arranged. In case of the device comprising a plurality of first guard rings 9, they are separated from each other by the drift layer 26. Thus, the first guard rings 9 are ring-shaped, i.e. they enclose each other in a plane parallel to the cathode side 31.

The inventive PCT comprises additionally on its anode side 41 a p doped anode layer 6, which has an anode layer thickness 62 measured from the anode side 41 and in orthogonal projection to it as the maximum depth, to which the layer extends. The anode layer 6 and base layer 5 are terminated in the inner region 22.

The anode layer thickness 62 is like the base layer thickness 52 at most 40 µm. The anode layer thickness 62 is an exemplary embodiment at least 8 µm, in another embodiment at least 10 µm.

Lateral to the anode layer 6 in the termination region 24, at least one p doped ring-shaped second guard ring 95 is arranged. In case of the device comprising a plurality of guard rings 95, they are separated from each other by the drift layer 26. Thus, the second guard rings 95 enclose each other in a plane parallel to the anode side 41. Typically, the guard rings 9, 95 have a width of 2 to 40 µm, in particular of 10 to 30 µm or 10 to 20 µm.

The guard rings 9, 95 are covered by a passivation layer, which connects the rings at the surface with a high resistivity semiconductive layer and a rubber layer for mechanical protection.

The surface passivation layer is for example formed by a combination of polysilicon (SIPOS) and silicon nitride layers or a diamond like carbon layer (DLC). The relevant parameters of the layers, e. g. thickness, conductivity, doping, and their interfaces have to be carefully optimized. Other passivation layers and their combination can also be used.

In another exemplary embodiment, the device comprises at least two or three first and/or second guard rings 9, 95, in yet another embodiment up to 20 or even 24 guard rings. Width and spacing of the guard rings can be optimized to achieve a high breakdown voltage. To improve the blocking capability and safe operation area during switching, a special not contacted resistive spacer between the guard rings 9, 95 and the base layer 5 / anode layer 6 likewise the channel stop regions can be used where necessary.

Of course, the conductivity types of all layers can be reversed, i.e. the layers of the first conductivity type like the drift layer 26 are in this case p type and the layers of the second conductivity type like the base layer 5 are n type.

An inventive PCT, which comprises a cathode contact 3 on a cathode side 31 and an anode contact 4 on an anode side 41 opposite the cathode side 31 can be manufactured by a method, which comprises at least the following manufacturing steps:

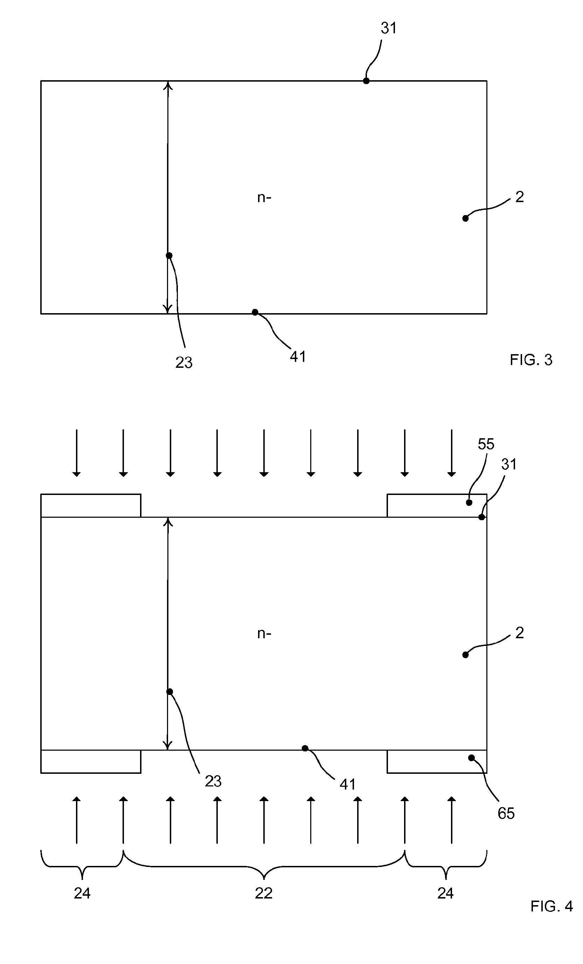

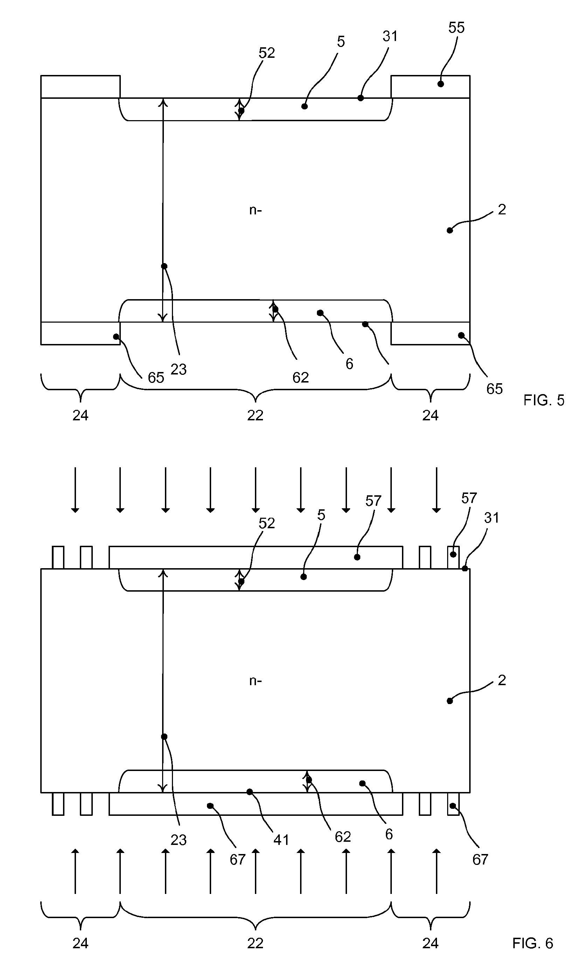

An (n-) doped wafer 2 with a cathode side 31 and an anode side 41 opposite to the cathode side 31 is provided (Fig. 3). As shown in Fig. 4, a base layer 5 is created on the cathode side 31 by applying a first mask 55 on the cathode side 31, which mask 55 covers a termination region 24 of the wafer. Then ions are applied, e.g. by ion implantation or deposition, e.g. from gas phase, on the cathode side 31 in the inner region 22 (arrows in Fig. 3). Ion implantation has the advantage that it provides very good reproducibility of doping profiles and does not introduce contaminants like classical dopant deposition at a surface, which requires high-temperature gettering at the end of high-temperature processes to remove these contaminants in order to achieve a good blocking. Afterwards the ions are diffused into the wafer 2 in the inner region 22 into a depth of at most 40 µm, in particular at most 30 µm, thus creating the base layer 5 with a base layer thickness 52 of at most 40 µm or at most 30 µm, respectively, from the cathode side 31 (Fig. 5). Afterwards the first mask 55 is removed.

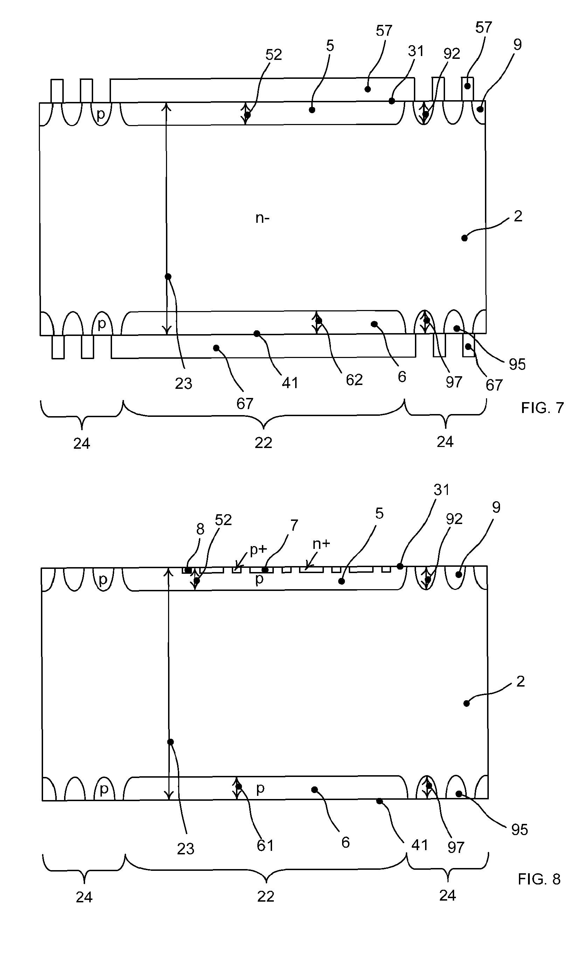

The first guard rings 9 can be created after or before the base layer 5. The first guard rings 9 are created on the cathode side 31 by applying a third mask 57 on the cathode side 31, which covers the inner region 22 of the wafer and within the termination region 24 those parts of the wafer, in which the doping concentration shall be kept unamended (Fig. 6). Then ions are applied (e.g. by implantation or deposition) on the cathode side 31 and diffused into the wafer 2 in the termination region 24 (Fig. 7). Afterwards the third mask 57 is removed. With this method, the first guard rings 9 may have a doping concentration and /or thickness different from the doping concentration and /or thickness of the base layer 5.

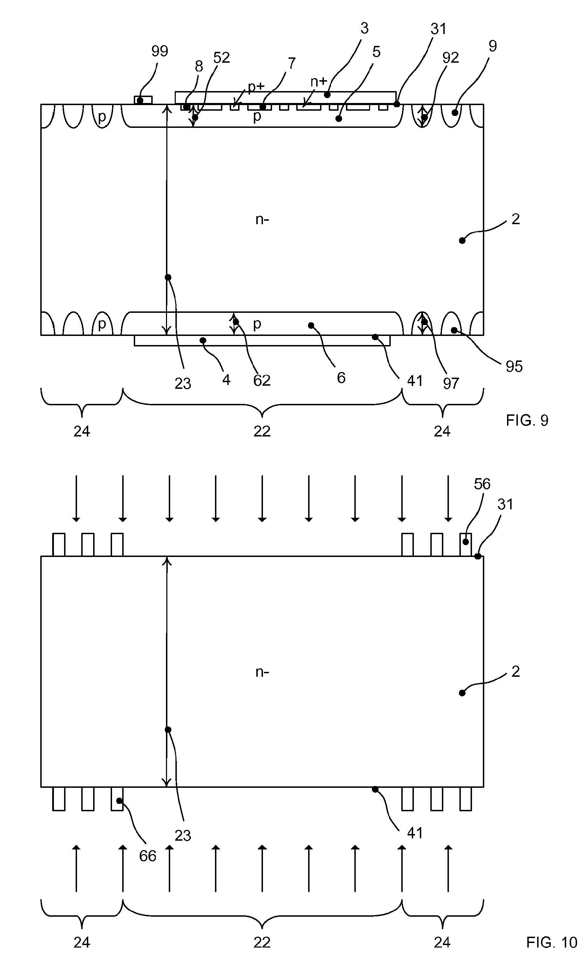

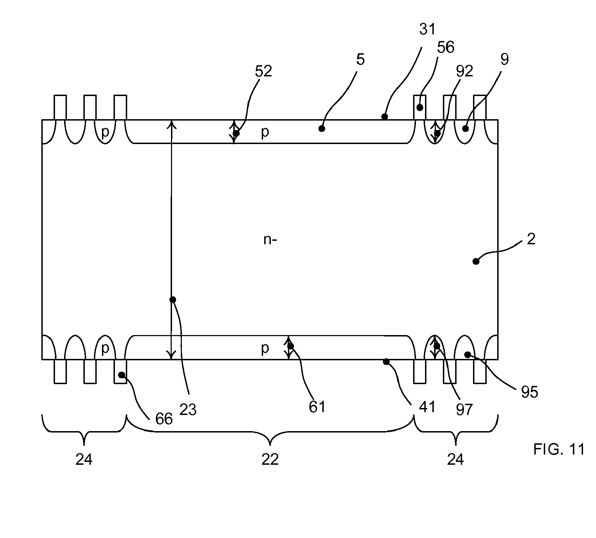

Alternatively, the first guard rings 9 and the base layer 5 are created simultaneously with a common cathode sided mask 56, in which an inner region 22 and those parts in a termination region 24, in which the first guard rings 9 are to be created are left uncovered (Fig. 10). Then ions are applied (arrows in Fig. 10) and diffused into the wafer, resulting in a base layer 5 and first guard rings 9 (Fig. 11). With such a method, the number of masks and steps for the deposition of dopants for the base layer 5 and first guard rings 9 is reduced. The doping concentration for the base layer 5 is the same as that of the first guard rings 9.

Of course, also variations of order of the manufacturing steps like separate implantation steps for the creation of the base layer 5 and first guard rings 9, but a common diffusion can be applied.

An anode layer 6 is created on the anode side 41 by applying a second mask 65 on the anode side 41, which mask covers a termination region 24 of the wafer (Fig. 4). Then ions are applied, e.g. by ion implantation or deposition, on the anode side 41 in the inner region 22 (Fig. 4). Afterwards the ions are diffused into the wafer 2 in the inner region 22 into a depth of at most 40 µm, in particular at most 300 µm, from the anode side 41, thus creating the anode layer 6 with an anode layer thickness 62 of at most 40 µm, or 30 µm respectively (Fig. 5). Afterwards the second mask 65 is removed.

Also the second guard rings 95 can be created after or before with the anode layer 6. The second guard rings 95 are created on the anode side 41 by applying a fourth mask 67 on the anode side 41, which covers the inner region 22 of the wafer and within the termination region 24 those parts of the wafer, in which the doping concentration shall be kept unamended (Fig. 6). Then ions are applied (e.g. by implantation or deposition) on the anode side 41 and diffused into the wafer 2 in the termination region 24 (Fig. 7). Afterwards the fourth mask 67 is removed. With this method, the second guard rings 95 may have a doping concentration and /or depth different from the doping concentration and /or depth of the anode layer 6.

Like the base layer 5 and first guard rings 9 on the cathode side 31, the second guard rings 95 can be created simultaneously with the anode layer 6 using an anode sided common mask 66, in which an inner region 22 and those parts in a termination region 24, in which the second guard rings 95 are to be created are left uncovered (Fig. 10). Then ions are applied (arrows in Fig. 10) and diffused into the wafer 2, resulting in an anode layer 6 and second guard rings 95 (Fig. 11). In this case, the number of masks and steps for the deposition of dopants the anode layer 6 are reduced and the anode layer 6 has the same doping concentration as that of the second guard rings 95.

It is possible to create the base and anode layer 5, 6 one after the other or they may be created completely together (as shown in Fig. 5), e.g. by depositing ions from the gas or solid phases on both sides simultaneously. It is also possible to create the layers partly together, e.g. by implanting ions on cathode or anode side, afterwards on the other side and then diffusing the ions in one step into the wafer 2. The same applies for the guard rings 9, 95.

It is also possible to use at the same time on the cathode and anode side 31, 41 common masks 56, 66 for the creation of the base layer 5 and first guard rings 9, and for the anode layer 6 and the second guard rings 95, and to apply ions at the same time on both sides as shown in Fig. 10 or alternatively, on one side after the other. Afterwards the ions can be diffused at the same time for the creation of the base layer 5, anode layer 6, first and second guard rings 9, 95.

That means the order of the creation for the base layer 5, anode layer 6, first and second guard rings 9, 95 can be chosen as desired.

Other layers like an n+-doped cathode layer 7, a p-doped cathode short region and a gate contact 95 may be created on the cathode side 31, i.e. after the creation of the base and anode layer 5, 6 as well as the guard rings 9, 95 now or at any other appropriate manufacturing step by any method known by the experts (Fig. 8).

Afterwards, the cathode and anode contacts 3, 4 are applied on the wafer 2 on the cathode side 31 and anode side 41, respectively, within the inner region 22 (Fig. 9).

### Reference List

- 1: phase controlled thyristor
- 10: prior art PCT
- 2: wafer
- 22: inner region
- 23: wafer thickness
- 24: termination region
- 26: drift layer
- 28: positive bevel
- 3: cathode contact
- 31: cathode side
- 4: anode contact
- 41: anode side
- 5: base layer
- 52: base layer thickness
- 55: first mask
- 56: cathode sided common mask
- 57: third mask
- 6: anode layer
- 62: anode layer thickness
- 65: second mask
- 66: anode sided common mask
- 67: fourth mask
- 7: cathode layer
- 72: cathode layer thickness
- 8: cathode short region
- 9: first Guard ring
- 92: first Guard ring thickness
- 95: second Guard ring
- 97: second Guard ring thickness
- 99: gate contact

## Claims

1. Bipolar reverse-blocking non-punch-through power semiconductor device with a blocking voltage of at least 1000 V comprising a semiconductor wafer (2) with an inner region (22) and a termination region (24), which surrounds the inner region (22), a cathode contact (3) being formed on a cathode side (31) of the wafer and an anode contact (4) being formed on an anode side (41) of the wafer opposite the cathode side (31),
said wafer (2) having a wafer thickness (23) measured between the cathode and anode side (31, 41),
said wafer (2) comprising:
- a drift layer (26) of a first conductivity type,
- a base layer (5) of a second conductivity type, which is arranged on the drift layer (26) towards the cathode side (31) and contacts the cathode contact (3), wherein the base layer (5) has a base layer thickness (52),
- an anode layer (6) of the second conductivity type, which is arranged on the drift layer (26) towards the anode side (41) and contacts the anode contact (4), wherein the anode layer (6) has a anode layer thickness (62),
- at least one first guard ring (9) of the second conductivity type with a first guard ring thickness (92) is arranged on the cathode side (31) in the termination region (24), each of which first guard rings (9) is separated from the base layer (5) and from any other first guard ring (9) by the drift layer (26),
**characterized in, that**
at least one second guard ring (95) of the second conductivity type with a second guard ring thickness (97) is arranged on the anode side (41) in the termination region (24), each of which second guard rings (95) is separated from the anode layer (6) and from any other second guard ring (95) by the drift layer (26), **in that**
the at least one first guard ring (9) and the at least one second guard ring (95) are floating, and **in that**
the base layer thickness (52) and the anode layer thickness (62) are at most 40 µm.

2. Semiconductor device according to claim 1, **characterized in that** the first guard ring thickness (92) is the same as the base layer thickness (52).

3. Semiconductor device according to claim 1 or 2, **characterized in that** the second guard ring thickness (97) is the same as the anode layer thickness (62).

4. Semiconductor device according to any of the claims 1 to 4, **characterized in that** at least one of the base layer thickness (52) and the anode layer thickness (62) is at least 8 µm.

5. Semiconductor device according to any of the claims 1 to 3, **characterized in that** at least one of the base layer thickness (52) and the anode layer thickness (62) is at least 10 µm.

6. Semiconductor device according to any of the claims 1 to 9, **characterized in that** the device comprises on the cathode side (31) a cathode layer (7) of the first conductivity type with a cathode layer thickness (72) and **in that** the base layer thickness (52) is larger than the cathode layer thickness (72).

7. Semiconductor device according to any of the claims 1 to 9, **characterized in that** at least one of the base layer thickness (52) and the anode layer thickness (62) are at most 30 µm.

8. Method for manufacturing a semiconductor device according to any of the claims 1 to 7, which comprises a cathode contact (3) on a cathode side (31) and an anode contact (4) on an anode side (41) opposite the cathode side (31), which method comprises at least the following manufacturing steps:
- a wafer (2) of a first conductivity type is provided,
- a base layer (5) is created on the cathode side (31) by applying a first mask (55) on the cathode side (31), which covers those parts of the wafer, in which the doping concentration shall be kept unamended,
- ions are applied on the cathode side (31) and diffused into the wafer (2) in the inner region (22) into a depth of at most 40 µm from the cathode side (31),
- the first mask (55) is removed,
- at least one first guard ring (9) is created on the cathode side (31) by applying a third mask (57) on the cathode side (31), which covers those parts of the wafer, in which the doping concentration shall be kept unamended,
- ions are applied on the cathode side (31) and diffused into the wafer (2) in the termination region (24),
- the third mask (57) is removed,
- an anode layer (6) is created by applying a second mask (65) on the anode side (41), which covers those parts of the wafer, in which the doping concentration shall be kept unamended,
- ions are applied on the anode side (41) and diffused into the wafer (2) in the inner region (22) into depth of at most 40 µm from the anode side (41),
- the second mask (65) is removed,
- an at least one second guard ring (95) is created by applying a fourth mask (67) on the anode side (41), which covers those parts of the wafer, in which the doping concentration shall be kept unamended,
- ions are applied on the anode side (41) and diffused into the wafer (2) in the termination region (24)
- the fourth mask (67) is removed,
- the cathode and anode contacts (3, 4) are applied on the wafer (2) on the cathode and anode side (31, 41) within the inner region (22).

9. Method for manufacturing a semiconductor device according to claim 8, **characterized in, that** the first and third mask (55, 57) are one common cathode sided mask (56), so that the base layer (5) and the at least one first guard ring (9) are created simultaneously.

10. Method for manufacturing a semiconductor device according to claim 8 or 9, **characterized in, that** the second and fourth mask (65, 67) are one anode sided common mask (66), so that the anode layer (6) and the at least one second guard ring (95) are created simultaneously.

11. Method for manufacturing a semiconductor device according to any of the claims 8 to 10, **characterized in, that** the ions for the creation of the base layer (5) and the anode layer (6) are applied simultaneously on the cathode side (31) and the anode side (41).

12. Method for manufacturing a semiconductor device according to any of the claims 8 to 11, **characterized in, that** the ions for the creation of the at least one first and second guard rings (9, 95) are applied simultaneously on the cathode side (31) and the anode side (41).

13. Method for manufacturing a semiconductor device according to any of the claims 8 to 12, **characterized in, that** at least one of
- the ions for the creation of the base layer (5) and the at least one first guard ring (9) are diffused into the wafer simultaneously and
- the ions for the creation of the anode layer (6) and the at least one second guard ring (95) are diffused into the wafer simultaneously.

14. Method for manufacturing a semiconductor device according to any of the claims 8 to 13, **characterized in, that** at least one of the base layer thickness (52) and the anode layer thickness (62) are at most 30 µm.
